# EUROPÄISCHE PATENTSCHRIFT

(11) **EP 0 580 162 B1**
(45) Veröffentlichungstag und Bekanntmachung des Hinweises auf die Patenterteilung: **09.09.1998**
(21) Anmeldenummer: 93111758.4
(22) Anmeldetag: 22.07.1993
(51) Int. Cl.: H01L 21/304, B24B 13/00

(54) **Verfahren zur Herstellung einer Halbleiterscheibe mit einer definiert geschliffenen, rotationssymmetrischen Krümmung**
Process for manufacturing a wafer with defined ground rotational symmetric warp
Procédé pour la fabrication d'un disque de semiconductor ayant une déformation définie avec une symmetrie de rotation

(30) Priorität: 23.07.1992 DE 4224395
(43) Veröffentlichungstag der Anmeldung: 26.01.1994
(73) Patentinhaber: Wacker Siltronic Gesellschaft für Halbleitermaterialien Aktiengesellschaft, 84489 Burghausen (DE)
(72) Erfinder: Huber, Anton, D-84489 Burghausen (DE); Langsdorf, Karl-Heinz, D-84489 Burghausen (DE)
(74) Vertreter: Rimböck, Karl-Heinz, Dr.

(56) Entgegenhaltungen:
- EP-A- 0 410 679
- CH-A- 574 612
- US-A- 2 699 633
- PATENT ABSTRACTS OF JAPAN vol. 010, no. 272 (E-437)16. September 1986 & JP-A-61 093 614 ( NEC CORP. ) 12. Mai 1986
- PATENT ABSTRACTS OF JAPAN vol. 015, no. 241 (E-1080)21. Juni 1991 & JP-A-3 076 119 ( SUMITOMO ELECTRIC INDUSTRIES, LTD. ) 2. April 1991
- PATENT ABSTRACTS OF JAPAN vol. 016, no. 146 (E-1188)10. April 1992 & JP-A-4 003 908 ( FUJITSU LIMITED ) 8. Januar 1992
- PATENT ABSTRACTS OF JAPAN vol. 007, no. 021 (E-155)27. Januar 1983 & JP-A-57 177 536 ( HITACHI SEISAKUSHO KK ) 1. November 1982

## Beschreibung

Die Erfindung betrifft ein Verfahren zur Herstellung einer Halbleiterscheibe mit einer definiert geschliffenen, rotationssymmetrischen Krümmung.

Bei der Herstellung von Halbleiterscheiben wird ein erheblicher Aufwand dafür getrieben, möglichst ebene Scheiben zu erhalten. Nur bei extrem ebener Scheibenoberfläche ist gewährleistet, daß das photolithographische Aufbringen elektronischer Bauelemente auf die Scheibenoberfläche in der mittlerweile üblichen Integrationsdichte fehlerfrei gelingt. Beginnend mit dem Heraussägen einer Scheibe aus einem stabförmigen Einkristall bis hin zur Oberflächenveredelung der Halbleiterscheibe durch Läpp- und Polierverfahren steht deshalb das Bestreben im Vordergrund, Halbleiterscheiben mit mindestens einer planen Oberfläche zu erhalten.

Im weiteren Verlauf der Bearbeitung einer Halbleiterscheibe sind jedoch in der Regel Verfahrensschritte notwendig, die die bis dahin erzielte Ebenheit der Halbleiterscheibe verschlechtern. Wegen der runden Scheibenform ist häufig nach einer einseitigen Behandlung einer Scheibenoberfläche eine rotationssymmetrische Krümmung der Halbleiterscheibe zu beobachten. So führt beispielsweise das Aufbringen oder Erzeugen einer oder mehrerer Materialschichten (z.B. durch Epitaxie oder Oxidation) auf eine bevorzugte Scheibenoberfläche zu Spannungen im Halbleitermaterial, die eine rotationssymmetrische Krümmung der Halbleiterscheibe verursachen. Ähnliches passiert, wenn eine Halbleiterscheibe einseitig geätzt, dotiert oder einer sogenannten Damagebehandlung - dem Erzeugen von Störstellen im Kristallgitter - unterworfen wird. Bei einer genauen Inspektion erweist sich eine derartig behandelte Halbleiterscheibe als durchgebogen.

Ein anerkanntes Maß für die Krümmung einer Halbleiterscheibe ist der sogenannte warp. Der warp gibt die Differenz zwischen dem maximalen und minimalen Abstand der Mittelebene der Halbleiterscheibe von einer Referenzebene an. Er ist beispielsweise in einem Meßverfahren gemäß der US-Norm ASTM F 657-80 bestimmbar. Durch die oben beschriebene einseitige Behandlung einer Halbleiterscheibe wird der warp, der bei ideal ebenen und planparallelen Scheibenoberflächen gleich null ist, vergrößert, es sei denn, die Halbleiterscheibe war bereits vor der einseitigen Behandlung definiert so verformt, daß die zusätzliche rotationssymmetrische Krümmung nahezu oder vollständig kompensiert wird. In diesem Fall würde der warp geringer und die für ein fehlerfreies, photolithographisches Aufbringen elektronischer Bauelemente notwendige, ebene Scheibengeometrie erreicht werden.

Die globale Dicken Variation (total thickness variation, TTV-Wert) einer Halbleiterscheibe ist besonders dazu geeignet, die Parallelität der Scheibenoberflächen zu beurteilen. Als TTV-Wert wird der Absolutbetrag der Differenz des maximalen und minimalen Dickenwertes einer Halbleiterscheibe aus einer Vielzahl von Punktmessungen bezeichnet. Der TTV-Wert ändert sich deshalb nicht, wenn sich eine Halbleiterscheibe in Folge einer einseitigen Behandlung ihrer Oberfläche verformt. Voraussetzung dafür ist allerdings, daß die Behandlung die Scheibendicke nicht ungleichmäßig verändert.

Aus der Offenlegungsschrift DE 39 06 091 A1 und der korrespondierenden Patentschrift US 4,991,475 ist bekannt, daß durch die Beeinflussung bestimmter Parameter beim Abtrennen von Halbleiterscheiben aus Kristallstäben mittels Innenlochsägen verformte Halbleiterscheiben erzeugt werden können. Allerdings reicht die Präzission dieses Verfahrens nicht aus, um reproduzierbar Halbleiterscheiben mit einer definierten rotationssymmetrischen Krümmung (mit einem definierten warp) herzustellen.

In den Patent Abstracts of Japan der JP-A-61093614 ist ein Verfahren beschrieben, nach dem besonders geformte Halbleiterscheiben hergestellt werden können. In den Patent Abstracts of Japan der JP-A-03-76119 ist offenbart, wie eine Halbleiterscheibe mit gekrümmter Oberfläche durch Schleifen hergestellt werden kann.

Gegenstand der vorliegenden Erfindung ist ein Verfahren zur Herstellung einer Halbleiterscheibe mit einer definiert geschliffenen, rotationssymmetrischen Krümmung (mit einem definiert geschliffenen warp). Die wesentlichen Merkmale des Verfahrens sind in Anspruch 1 zusammengefaßt.

Eine nach dem Verfahren hergestellte Halbleiterscheibe besitzt eine rotationssymmetrisch gekrümmte Vorderseite und eine parallel zur Vorderseite verlaufende Rückseite. Die Krümmung der Vorderseite ist in die Oberfläche der Halbleiterscheiben eingeschliffen. Vorzugsweise ist die rotationssymmetrische Krümmung konkav, konvex oder kegelförmig ausgebildet. Der Verformungsgrad der Halbleiterscheibe, ausgedrückt durch deren warp, ist definiert eingestellt. Die Voreinstellung des warps wird nachstehend beschrieben.

Zunächst wird in an sich bekannter Weise eine Halbleiterscheibe beispielsweise von der Stirnseite eines stabförmigen Halbleiterkristalls mittels einer Innenlochsäge abgetrennt. Es ist darauf zu achten, daß das gewählte Sägeverfahren mindestens eine möglichst ebene Scheibenoberfläche hinterläßt. Vorzugsweise wird durch ein vorheriges, stirnseitiges Schleifen des Kristallstabes eine plangeschliffene Oberfläche auf einer Seite der entstehenden Halbleiterscheibe erzeugt. Ein derartiges Sägeverfahren ist in der Patentschrift DE 36 13 132 C2 und in der korrespondierenden Patentschrift US 4,896,459 beschrieben.
Die vom Kristallstab abgetrennte Halbleiterscheibe wird anschließend mit ihrer ersten Oberfläche auf den Aufnehmer einer Oberflächenschleifmaschine gelegt. Als erste Oberfläche der Halbleiterscheibe gilt diejenige Scheibenseite, welche die größere Ebenheit aufweist. Wurde die Stirnseite des Kristallstabes vor dem Abtrennen der Halbleiterscheibe plangeschliffen, wird die Halbleiterscheibe mit der plangeschliffenen Oberfläche auf den Scheibenaufnehmer gelegt. Die gegenüberliegende zweite Oberfläche der Halbleiterscheibe wird anschließend in einem ersten Schleifschritt geschliffen. Als Oberflächenschleifmaschinen eignen sich besonders Einzelscheiben-Schleifmaschinen, die nach dem in der Europäischen Patentanmeldung EP 272 531 A1 offenbarten Funktionsprinzip des Oberflächenrotations-Schleifens arbeiten. Hierbei rotieren sowohl der Scheibenaufnehmer mit der darauf fixierten Halbleiterscheibe, als auch das axial zugestellte Schleifwerkzeug (z.B. eine Teller- oder Umfangschleifscheibe). Während des Schleifens der zweiten Oberfläche der Halbleiterscheibe im ersten Schleifschritt ist darauf zu achten, daß die Drehachse des Schleifwerkzeugs gegenüber der Drehachse des Scheibenaufnehmers geneigt ist. Durch diese Maßnahme entsteht eine Halbleiterscheibe mit einer rotationssymmetrisch gekrümmten Oberfläche. Die Krümmung der Scheibenoberfläche ist vom Neigungswinkel, den die Drehachsen von Scheibenaufnehmer und Schleifwerkzeug während des Oberflächenrotations-Schleifens zueinander einnehmen, abhängig und deshalb definiert einstellbar.

Nach dem ersten Schleifschritt des Verfahrens wird die Halbleiterscheibe umgedreht und mit der gerade geschliffenen, zweiten Oberfläche auf einem Scheibenaufnehmer fixiert. Die gesamte zweite Oberfläche der Halbleiterscheibe muß berührend auf dem Scheibenaufnehmer aufliegen. Vorzugsweise wird die Halbleiterscheibe auf einen Vakuumaufnehmer gesaugt, so daß sie sich vollständig an die Aufnehmerfläche anschmiegt. In diesem Zustand wird nun die erste Scheibenoberfläche in einem zweiten Schleifschritt des Verfahrens parallel zur Aufnehmerfläche des Scheibenaufnehmers geschliffen. Neben dem bereits erwähnten Oberflächenrotations-Schleifen sind hierfür auch Tauchschleif- und Planseitenschleif-Verfahren verwendbar. Bei letzteren rotiert nur das Schleifwerkzeug.

Beim Entspannen vom Scheibenaufnehmer nach dem zweiten Schleifschritt federt die Halbleiterscheibe in eine Form zurück, die maßgeblich durch den ersten Schleifschritt geprägt ist. Die Scheibenoberflächen sind rotationssymmetrisch gekrümmt und verlaufen parallel zueinander. Die Halbleiterscheibe besitzt eine definiert geschliffene, rotationssymmetrische Krümmung (einen definiert geschliffenen warp), die (der) im ersten Schleifschritt durch die Wahl des Neigungswinkels, den die Drehachsen von Schleifwerkzeug und Scheibenaufnehmer zueinander einnehmen, bestimmt wird.

Das Verfahren ist auf alle Halbleiterscheiben anwendbar, die hinreichend elastisch sind und sich ohne zu zerbrechen im zweiten Schleifschritt so auf einen Scheibenaufnehmer legen lassen, daß die zur Aufnehmerfläche weisende Scheibenoberfläche vollständig berührend auf dieser aufliegt. Mit dem Verfahren ist ein umso größerer warp einstellbar, je größer der Durchmesser und je kleiner die Dicke der verwendeten Halbleiterscheibe ist. Für Siliciumscheiben, die sich besonders gut für das Verfahren eignen, sind allerdings rotationssymmetrische Krümmungen erreichbar, die ein mehrfaches über dem liegen, was an warp durch eine einseitige Behandlung einer Scheibenoberfläche zu erwarten ist. Typischerweise beträgt der warp bei einseitig behandelten Siliciumscheiben bis zu ca. 50 µm bei Scheiben mit 200 mm Durchmesser und bis zu ca. 150 µm bei Scheiben mit 100 mm Durchmesser.

Die Genauigkeit, mit der der warp einer Halbleiterscheibe nach dem erfindungsgemäßen Verfahren eingestellt werden kann, hängt von der Ebenheit der Halbleiterscheibe vor dem ersten Schleifschritt und von der Genauigkeit, mit der die Drehachse des Schleifwerkzeugs während des ersten Schleifschritts ausgerichtet werden kann, ab. Mit derzeit handelsüblichen Maschinen ist bei Siliciumscheiben eine warp-Einstellung mit einer Genauigkeit < 2 µm möglich.

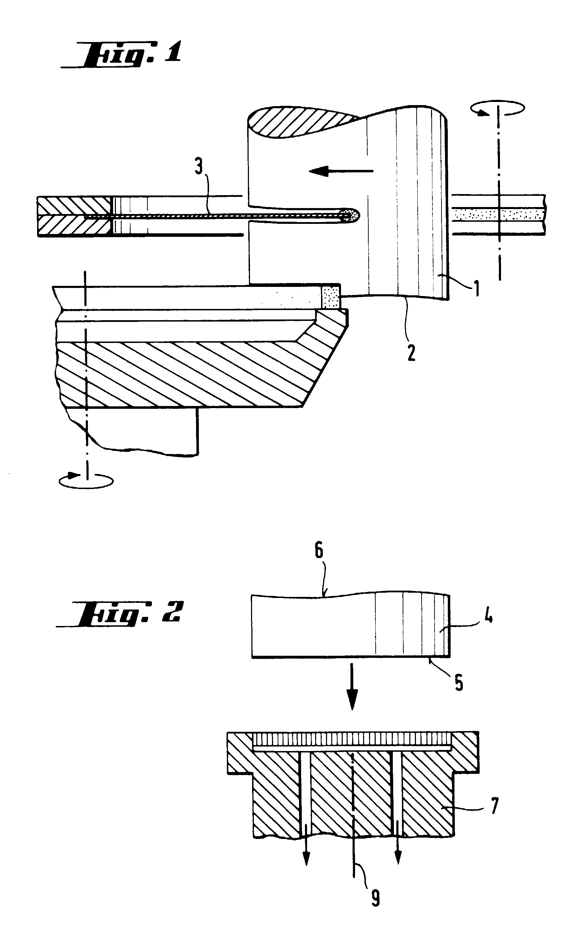

Eine besonders bevorzugte Ausführungsform des Verfahrens wird nachfolgend an Hand der Figuren 1 bis 7, in denen schematisch Momentaufnahmen der einzelnen Verfahrensschritte dargestellt sind, im Detail erklärt. Selbstverständlich ist die Erfindung nicht auf diese Ausführungsform beschränkt. Die einzelnen Verfahrensschritte sind:
- Figur 1: stirnseitiges Planschleifen des Kristallstabes und Abtrennen einer Halbleiterscheibe
- Figur 2: Fixieren der Halbleiterscheibe mit der ersten, plangeschliffenen Oberfläche auf einem Scheibenaufnehmer
- Figur 3: Schleifen der Halbleiterscheibe mit einer gegenüber der Drehachse des Scheibenaufnehmers geneigten Drehachse des Schleifwerkzeugs
- Figur 4: Auflegen der Halbleiterscheibe mit der zweiten Oberfläche auf einen Scheibenaufnehmer
- Figur 5: Fixieren der Halbleiterscheibe auf dem Scheibenaufnehmer
- Figur 6: Schleifen der Scheibenoberfläche parallel zur Aufnehmerfläche des Scheibenaufnehmers
- Figur 7: Entfernen der Halbleiterscheibe vom Aufnehmer.

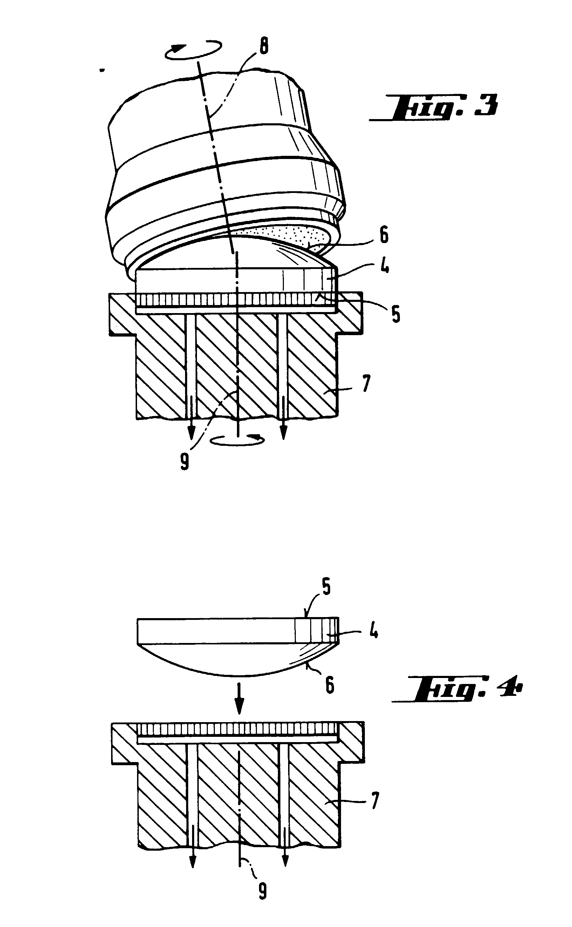

Figur 1 zeigt das Abtrennen einer Halbleiterscheibe von der Stirnseite eines stabförmigen Halbleiterkristalls 1. Es ist unerheblich, ob das Schleifen der Stabstirnfläche 2 erfolgt bevor oder während das Sägeblatt der Innenlochsäge 3 die Halbleiterscheibe abtrennt. Die resultierende Halbleiterscheibe 4 hat eine plangeschliffene, erste Oberfläche 5 und eine üblicherweise weniger ebene, zweite Oberfläche 6 (Figur 2). Die Halbleiterscheibe wird mit der ersten Oberfläche auf dem Aufnehmer 7 einer Oberflächenrotations-Schleifmaschine aufgelegt und beispielsweise durch Anlegen eines Vakuums darauf fixiert. Der Aufnehmer rotiert mit der aufgelegten Halbleiterscheibe während des nachfolgenden Oberflächenschleifens. Aus Figur 3 ist ersichtlich, daß bei diesem ersten Schleifschritt des Verfahrens die Drehachse 8 des Schleifwerkzeugs gegenüber der Drehachse 9 des Aufnehmers geneigt ist. Die geschliffene Scheibenoberfläche erhält durch den ersten Schleifschritt ein gekrümmtes Aussehen. Die Krümmung der Oberfläche ist rotationssymmetrisch und in Abhängigkeit der eingestellten, geneigten Anordnung der Drehachsen konkav, konvex oder kegelförmig.

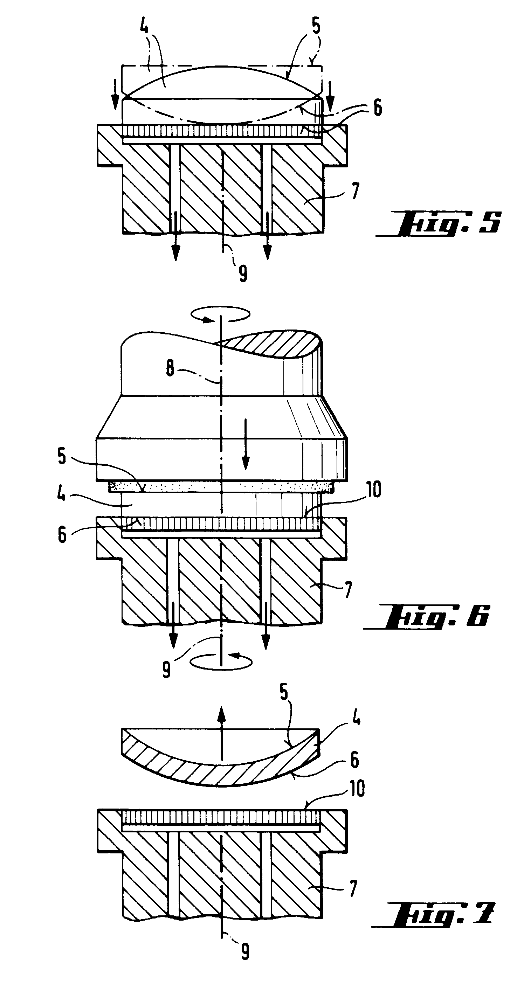

Gemäß Figur 4 wird die Halbleiterscheibe umgedreht und mit der nun gekrümmten, zweiten Oberfläche 6 auf einen Scheibenaufnehmer 7 aufgelegt. Vorzugsweise wird ein Vakuumaufnehmer verwendet und die Halbleiterscheibe angesaugt, so daß sie mit der gesamten zweiten Oberfläche berührend auf der Aufnehmerfläche aufliegt. Wie in Figur 5 angedeutet, überträgt sich die Krümmung der angesaugten Scheibenoberfläche, bedingt durch die Elastizität des Halbleitermaterials, auf die gegenüberliegende, erste Oberfläche 5 der Halbleiterscheibe. Dies ist nur solange der Fall, wie die Halbleiterscheibe auf dem Scheibenaufnehmer fixiert ist.

In Figur 6 wird gezeigt, wie die freie, erste Oberfläche der auf dem Vakuumaufnehmer angesaugten Halbleiterscheibe in einem zweiten Schleifschritt parallel zur Aufnehmerfläche überschliffen wird. Die Aufnehmerfläche 10 ist in der Figur zwar eben und waagrecht gezeichnet, dies muß jedoch nicht notwendigerweise der Fall sein. Die Aufnehmerfläche könnte auch eine andere Form haben, beispielsweise kegelförmig ausgebildet sein. In solchen Fällen ist es nur aufwendiger, die erste Scheibenoberfläche parallel zur Aufnehmerfläche zu schleifen, weil die Drehachsen des Aufnehmers und des Schleifwerkzeugs in geeigneter Weise geneigt sein müssen.

Wird die Halbleiterscheibe nach dem Überschleifen vom Vakuumaufnehmer genommen, wie in Figur 7 dargestellt, so federt sie in ihre entspannte Form zurück. Die Scheibenoberflächen 5,6 bleiben dabei parallel zueinander. Die Halbleiterscheibe ist entsprechend der Krümmung der zweiten Scheibenoberfläche infolge des ersten Schleifschrittes definiert rotationssymmetrisch gekrümmt. Der warp der nach dem zweiten Schleifschritt resultierenden Halbleiterscheibe ist durch die geneigte Stellung der Drehachsen von Schleifwerkzeug und Aufnehmer im ersten Schleifschritt definiert einstellbar.

Die Krümmung der Halbleiterscheibe ist relativ zur Kristallstruktur ausgeprägt, so daß die Halbleiterscheiben mit üblichen Fertigungsmethoden, wie Läppen, Ätzen oder Polieren weiterbehandelt werden können, ohne daß dabei die eingestellte rotationssymmetrische Krümmung beeinträchtigt wird.

Nach dem vorgestellten Verfahren werden vorteilhafterweise oberflächengeschliffene Halbleiterscheiben hergestellt, deren warp so gewählt ist, daß die bei einer einseitigen Scheibenbehandlung zu erwartende Scheibenverformung kompensiert wird, so daß nach einer solchen Behandlung Halbleiterscheiben mit planparallelen Oberflächen zur Verfügung stehen.

Die Erfindung wird nachfolgend an Hand eines Beispiels dargelegt:

Von einem stabförmigen Siliciumeinkristall wurden insgesamt 18 Halbleiterscheiben mittels einer Innenlochsäge abgetrennt. Vor jedem Sägevorgang wurde die Stabstirnfläche plangeschliffen. Die entstandenen Halbleiterscheiben besaßen einen Durchmesser von 200 mm und eine Dicke von 760 µm. Je 6 Stück dieser Halbleiterscheiben sollten nach dem erfindungsgemäßen Verfahren mit einem definierten warp von 25 µm, 45 µm und 75 µm versehen werden. Beim Oberflächenrotations-Schleifen im ersten Schleifschritt war die Drehachse des Schleifwerkzeugs gegen die Drehachse des Scheibenaufnehmers geneigt, so daß die geschliffene Scheibenoberfläche die Form einer Kugelkalotte annahm. Die Halbleiterscheiben lagen während dieses Schleifschritts mit ihrer, beim Stirnschleifen des Kristalls plangeschliffenen, Oberfläche auf einem Vakuumaufnehmer. Der Neigungswinkel der Drehachsen war so gewählt, daß die geschliffene Halbleiterscheibe einen TTV-Wert aufwies, der dem angestrebten warp entsprach. Die Kalottenform und die Kalottenhöhe wurden mit Hilfe eines induktiven Differenzmeßtasters überprüft. Eine derartig geschliffene Scheibe wurde anschließend umgedreht, und auf dem Vakuumaufnehmer angesaugt, so daß die zum Aufnehmer weisende Scheibenoberfläche vollständig mit der Aufnehmerfläche in Berührung stand. In einem zweiten Schleifschritt wurde die Drehachse des rotierenden Schleifwerkzeugs so ausgerichtet, daß die Halbleiterscheibe parallel zur Aufnehmerfläche geschliffen wurde. Die fertig geschliffenen Halbleiterscheiben wurden einer üblichen, von der Scheibenoberfläche gleichmäßig Material abtragenden, Behandlung durch Ätzen unterworfen, um ein oberflächennahes Damage als Folge der Schleifbehandlungen zu entfernen. Von diesen Scheiben wurden schließlich der TTV-Wert als Maß für die Parallelität einer Scheibe und der warp als Maß für die Krümmung der Scheibe bestimmt. Der warp wurde flächendeckend mit einem handelsüblichen Warpmeßgerät gemessen. Den in der Tabelle aufgeführten Meßergebnissen ist zu entnehmen, daß die im ersten Schleifschritt eingestellten TTV-Werte gut mit dem warp der fertig geschliffenen Halbleiterscheiben korrelieren und nur minimal vom angestrebten warp streuen. Ferner sind die Oberflächen der erzeugten Halbleiterscheiben nahezu parallel.

**Tabelle:**

| Scheiben-Nr. 72.5 | | TTV-1 | TTV-2 | warp-2 | 1 | 74 | 2.4 |
|---|---|---|---|---|---|---|---|
| 2 | 76 | 2.7 | 70.4 | | | | |
| 3 | 74 | 2.8 | 71.7 | | | | |
| 4 | 74 | 4.9 | 71.5 | | | | |
| 5 | 74 | 3.1 | 72.7 | | | | |
| 6 | 79 | 3.3 | 73.2 | | | | |
| | | | | | | | |
| 7 | 47 | 2.7 | 46.8 | | | | |
| 8 | 48 | 2.8 | 45.6 | | | | |
| 9 | 47 | 2.3 | 44.4 | | | | |
| 10 | 47 | 2.9 | 44.1 | | | | |
| 11 | 47 | 2.4 | 44.7 | | | | |
| 12 | 46 | 3.2 | 43.0 | | | | |
| | | | | | | | |
| 13 | 26 | 2.3 | 24.4 | | | | |
| 14 | 27 | 2.4 | 25.6 | | | | |
| 15 | 25 | 1.9 | 24.8 | | | | |
| 16 | 27 | 2.1 | 25.7 | | | | |
| 17 | 26 | 2.6 | 24.0 | | | | |
| 18 | 27 | 2.8 | 24.9 | | | | |
| TTV-1: TTV-Wert nach dem ersten Schleifschritt in µm TTV-2: TTV-Wert nach dem zweiten Schleifschritt und Ätzen in µm warp-2: warp nach dem zweiten Schleifen und der Behandlung durch Ätzen in µm | | | | | | | |

## Patentansprüche

1. Verfahren zur Herstellung einer Halbleiterscheibe mit einer definiert geschliffenen, rotationssymmetrischen Krümmung, indem eine Halbleiterscheibe mit elastischen Eigenschaften von einem Halbleiterkristall (1) abgetrennt wird, die Halbleiterscheibe mit einer ersten planaren Oberfläche (5) auf einem Scheibenaufnehmer (7) fixiert wird und eine gegenüberliegende zweite Oberfläche (6) der Halbleiterscheibe in einem ersten Schleifschritt geschliffen wird, so daß die rotationssymmetrische Krümmung entsteht, wobei während des Schleifens das Schleifwerkzeug und der Scheibenaufnehmer rotieren und die Drehachse des Schleifwerkzeuges gegenüber der Drehachse des Scheibenaufnehmers (7) geneigt ist, und indem in einem zweiten Schleifschritt die erste Oberfläche (5) der Halbleiterscheibe parallel zur Aufnahmefläche eines Scheibenaufnehmers geschliffen wird, wobei während des Schleifens die gesamte zweite Oberfläche der Halbleiterscheibe berührend mit dem Scheibenaufnehmer verbunden ist.

2. Verfahren gemäß Anspruch 1, dadurch gekennzeichnet, daß die Halbleiterscheibe von einem stirnseitig plangeschliffenen Halbleiterkristall abgetrennt wird und die plangeschliffene Oberfläche der resultierenden Halbleiterscheibe die erste Oberfläche der Halbleiterscheibe ist.

3. Verfahren gemäß Anspruch 1 oder Anspruch 2, dadurch gekennzeichnet, daß die definiert geschliffene rotationssymmetrische Krümmung der Halbleiterscheibe eine Krümmung der Halbleiterscheibe kompensiert, die bei einer einseitigen Behandlung der Halbleiterscheibe zu erwarten ist.

## Claims

1. Method of producing a semiconductor wafer with a rotationally symmetrical curvature ground in a defined way, in that a semiconductor wafer with elastic properties is cut from a semiconductor crystal (1), the semiconductor wafer is fixed on a wafer pickup (7) by means of a first planar surface (5) and an opposite, second surface (6) of the semiconductor wafer is ground in a first grinding step, so that the rotationally symmetrical curvature is formed, the grinding tool and the wafer pickup rotating during the grinding and the axis of rotation of the grinding tool being inclined with respect to the axis of rotation of the wafer pickup (7), and in that the first surface (5) of the semiconductor wafer is ground parallel to the pickup face of a wafer pickup in a second grinding step, the entire second surface of the semiconductor wafer being joined tangentially to the wafer pickup during the grinding.

2. Method according to Claim 1, characterized in that the semiconductor wafer is cut from a semiconductor crystal which is surface-ground at the end face and the surface-ground surface of the resultant semiconductor wafer is the first surface of the semiconductor wafer.

3. Method according to Claim 1, or Claim 2, characterized in that the rotationally symmetrical curvature, ground in a defined way, of the semiconductor wafer compensates a curvature of the semiconductor wafer which is to be expected in the case of a single-sided treatment of the semi-conductor wafer.

## Revendications

1. Procédé de fabrication d'une plaquette en semi-conducteur ayant une courbure rectifiée de manière définie et avec une symétrie de rotation, dans lequel une plaquette en semi-conducteur dotée de propriétés élastiques est découpée dans un cristal semi-conducteur (1), la plaquette en semi-conducteur est fixée sur un support de plaquette (7) par une première face plane (5) et une deuxième face opposée (6) de la plaquette en semi-conducteur est rectifiée au cours d'une première opération de rectification de manière à produire la courbure à symétrie de rotation, l'outil de rectification et le support de plaquette se trouvant en rotation durant la rectification et l'axe de rotation de l'outil de rectification étant incliné par rapport à l'axe de rotation du support de plaquette (7), et dans lequel, au cours d'une deuxième opération de rectification, la première face (5) de la plaquette en semi-conducteur est rectifiée parallèlement à la surface d'appui du support de plaquette, la totalité de la deuxième face de la plaquette en semi-conducteur étant reliée par contact au support de plaquette durant la rectification.

2. Procédé suivant la revendication 1, caractérisé en ce que la plaquette en semi-conducteur est découpée dans un cristal semi-conducteur dont la face d'about a subi une rectification plane et en ce que la face rendue plane de la plaquette en semi-conducteur ainsi produite est la première face de la plaquette en semi-conducteur.

3. Procédé suivant la revendication 1 ou 2, caractérisé en ce que la courbure rectifiée de manière définie et avec symétrie de rotation de la plaquette en semi-conducteur compense une courbure de la plaquette en semi-conducteur à laquelle on doit s'attendre lors du travail d'une seule face de la plaquette en semi-conducteur.
